# EUROPEAN PATENT APPLICATION

(11) **EP 2 840 606 A2**
(43) Date of publication of application: **25.02.2015**
(21) Application number: 14180133.2
(22) Date of filing: 07.08.2014
(51) Int. Cl.: H01L 23/498

(54) **Semiconductor package**

(30) Priority: 20.08.2013 JP 2013170786
(71) Applicant: Funai Electric Co., Ltd., Daito city Osaka 574-0013 (JP)
(72) Inventor: Ohara, Hisayuki, Osaka Osaka 574-0013 (JP)
(74) Representative: Osha Liang SARL

(57) **Abstract**

A semiconductor package (100, 300, 500, 700, 900A, 900B, 1000A, 1000B) comprises a substrate (120, 520, 920A, 920B, 1020) comprising a top surface and a back surface, a semiconductor chip (110) having a plurality of functions and mounted on the top surface of the substrate (120, 520, 920A, 920B, 1020), and a plurality ofballs (130, 330, 530, 730, 930A, 930B, 1030A, 1030B) formed on the back surface of the substrate (120, 520, 920A, 920B, 1020) configured to connect the substrate (120, 520, 920A, 920B, 1020) to an external substrate of the semiconductor package (100, 300, 500, 700, 900A, 900B, 1000A, 1000B). The substrate (120, 520, 920A, 920B, 1020) further comprises a plurality of electrodes (121, 521) that correspond to the plurality of functions and are formed on the back surface of the substrate (120, 520, 920A, 920B, 1020), and a subset of the plurality of electrodes (121, 521) corresponds to a subset of the plurality of functions, and each of the plurality of balls (130, 330, 530, 730, 930A, 930B, 1030A, 1030B) is respectively disposed on each of the electrodes in the subset.

## Description

### [Technical Field]

The present invention relates generally to a semiconductor package.

### [Background Art]

In recent years, in conjunction with the miniaturization of large scale integration (LSI) design rules, the integration of semiconductor chips has been increasing. Particularly, in semiconductor chips installed in ball grid array (BGA) packages, having one semiconductor chip that has a large number of functions is increasing. For this reason, balls used for signal and power connections are increasing and narrowing of the pitch between balls is progressing. Therefore, there is a demand for configurations that can correspond to the narrowing of the pitch between balls and an increase in the number of balls, in semiconductor packages and printed circuit boards on which the semiconductor packages are mounted.

Such configuration is proposed, for example, in a configuration providing projections formed to encompass the balls on the mounting surface of the printed circuit board of the semiconductor package (for example, see Patent Document 1). This can prevent short-circuiting caused by adjacent balls contacting during the mounting of the semiconductor package.

### [Related Art Documents]

### [Patent Documents]

[Patent Document 1] Japanese Unexamined Patent Application Publication 2000-277655

However, in the above configuration, although short circuiting between adjacent balls can be suppressed, it does not facilitate substrate design of the printed circuit board where the semiconductor package is mounted. Specifically, substrate design of printed circuit boards is increasingly difficult due to the increase in the number of balls and on account of demands in printed circuit boards for miniaturizing patterns, increasing the number of conductor layers, adopting non-through vias, and the like. Also, depending on the narrowing of the pitch between balls, the miniaturization of the pattern, the reduction in diameter of the via holes, and the like required in printed circuit boards also leads to difficulty in the substrate design of the printed circuit board. In this way, the narrowing of the pitch between balls in the semiconductor package as well as the increase in the number of balls has made substrate design of printed circuit boards difficult.

Incidentally, the semiconductor package that uses one semiconductor chip with a large number of functions as described above, in actuality may only use a portion of the functions from among the large number of functions. In this way, even if it there is no need to use all of the functions in the semiconductor chip, all of the balls corresponding to all of the functions exist in the semiconductor package. In other words, there are unused balls corresponding to functions that are not used. These unused balls increase the wasteful cost of the semiconductor package as well as make the substrate design of the printed circuit board difficult.

A method that designs a semiconductor package corresponding to a portion of functions used from among the large number of functions is conceivable to eliminate unused balls. As such, a method, for example, that individually designs a substrate for each function used where the semiconductor chip and the substrate, which is the board where the semiconductor chip is mounted, included in the semiconductor package are used in common, regardless of the functions used by the semiconductor chip, is conceivable. However, to do that, requires designing a plurality of substrates corresponding to one semiconductor chip, which is not easily realized.

In this way, both eliminating unused balls and having a common substrate regardless of the functions used is difficult.

### [Summary of the Invention]

One or more embodiments of the invention provide a semiconductor package that can operate by a portion of functions among a plurality of functions and that can reduce the production of wasteful balls unrelated to operation by using a semiconductor chip that can operate a by plurality of functions and a substrate to operate the semiconductor chip by the plurality of functions.

According to one or more embodiments, a semiconductor package may comprise: a substrate comprising a top surface and a back surface; a semiconductor chip having a plurality of functions and mounted on the top surface of the substrate; and a plurality of balls formed on the back surface of the substrate configured to connect the substrate to an external substrate of the semiconductor package, wherein, the substrate may further comprise a plurality of electrodes that correspond to the plurality of functions and are formed on the back surface of the substrate, and a subset of the plurality of electrodes may correspond to a subset of the plurality of functions, and each of the plurality of balls is respectively disposed on each of the electrodes in the subset.

In this manner, the plurality of balls may be formed on the plurality of electrodes corresponding to a portion of functions among the plurality of functions. By this, for example, a semiconductor package can operate by a portion of the functions among the plurality of functions and can reduce the production of wasteful balls unrelated to operation by using a semiconductor chip that can operate by a plurality of functions and a substrate to operate the semiconductor chip by the plurality of functions.

According to one or more embodiments, the back surface of the substrate may comprise a plurality of regions corresponding to the plurality of functions, and each of the plurality of electrodes may be respectively formed in the corresponding regions of the plurality of regions.

According to one or more embodiments of the invention, the electrodes in the subset that correspond to the subset of functions may be disposed in a zigzag pattern,

According to one or more embodiments, the electrodes not in the subset correspond to functions other than the functions in the subset and may be disposed adjacent to the electrodes that correspond to the subset of the functions.

In this manner, the plurality of electrodes corresponding respectively to a portion of the functions among the plurality of electrodes may be disposed in a zigzag pattern. As a result, for example, the semiconductor package can be prevented from tipping when mounting the semiconductor package. Furthermore, for example, the stress on the substrate can be distributed and failure of the semiconductor package from the deflection of the substrate can be reduced.

According to one or more embodiments, a shape of the substrate as viewed from a direction perpendicular to the back surface may be substantially rectangular, each region of the substrate divided by line segments connecting the center of the substantially rectangular shape to midpoints of each side that configure the substantially rectangular shape may be a quadrant.

According to one or more embodiments, each quadrant may contain the same number of electrodes corresponding to the portion of the functions.

In this manner, for example, the semiconductor package can be further prevented from tilting when mounting the semiconductor package.

According to one or more embodiments, the plurality of electrodes may comprise power electrodes that correspond to the subset of the functions and correspond to power or ground of the functions, wherein the power electrodes are formed on the center of the back surface of the substrate.

According to one or more embodiments, the substrate may further comprise evaluation electrodes formed on the back surface of the substrate.

In this manner, for example, evaluation may be done by forming evaluation balls on the evaluation electrodes at the time of evaluation, but in the final products shipped to the user, a form excluding these balls may be provided. Therefore, they may be used without publishing the existence of the evaluation balls to the user.

With one or more embodiments of the present invention, a semiconductor package can operate by a portion of functions among a plurality of functions and can reduce the production of wasteful balls unrelated to operation by using a semiconductor chip that can operate by a plurality of functions and a substrate to operate the semiconductor chip by the plurality of functions.

### [Brief Description of the Drawings]

FIG. 1 is an exploded perspective view of a semiconductor package according to one or more embodiments of a first example.
FIG. 2A is a plan view of a substrate before the plurality of balls are formed as viewed from the back surface side, according to one or more embodiments of the first example.
FIG. 2B is a plan view of the substrate after the plurality of balls are formed as viewed from the back surface side, according to one or more embodiments of the first example.
FIGS. 3A and 3B are diagrams for describing the semiconductor package according to one or more embodiments of the first example mounted on the printed circuit board.
FIGS. 4A and 4B are diagrams for describing the semiconductor package according to a comparative example mounted on the printed circuit board.
FIG. 5 is a diagram for describing the disposal of a plurality of balls formed on the substrate according to one or more embodiments of the first example.
FIG. 6A is a plan view of a substrate before the plurality of balls are formed in the semiconductor package according to one or more embodiments of a second example as viewed from the back surface side.
FIG. 6B is a plan view of the substrate after the plurality of balls are formed as viewed from the back surface side, according to one or more embodiments of the second example.
FIGS. 7A and 7B are diagrams for describing the semiconductor package according to one or more embodiments of the second example mounted on the printed circuit board.
FIGS. 8A and 8B are diagrams for describing the semiconductor package according to a comparative example mounted on the printed circuit board.
FIGS. 9A and 9B are diagrams for describing the semiconductor package according to one or more embodiments of a third example.
FIG. 10A is a plan view of a semiconductor package that can operate by only basic functions as viewed from the back surface side of the substrate, according to one or more embodiments of the third example.
FIG. 10B is a plan view of the semiconductor package that can operate by basic functions and additional functions as viewed from the back surface side of the substrate, according to one or more embodiments of the third example.
FIG. 11A is a plan view of the semiconductor package at the time of evaluation as viewed from the back surface side of the substrate according to one or more embodiments of a fourth example.
FIG. 11B is a plan view of the semiconductor package at the time of shipping as viewed from the back surface side of the substrate according to one or more embodiments of the fourth example.

### [Detailed Description of Embodiments]

Embodiments of the present invention are described in detail below using drawings. Each of the examples described below illustrate various embodiments of the present invention. Numeric values, shapes, materials, components, disposed positions of components, and modes of connection described herein are for illustration purposes and are not intended to limit the scope of the present invention. The present invention is specified by the scope of the claims.

### (First example)

### [Overall Configuration]

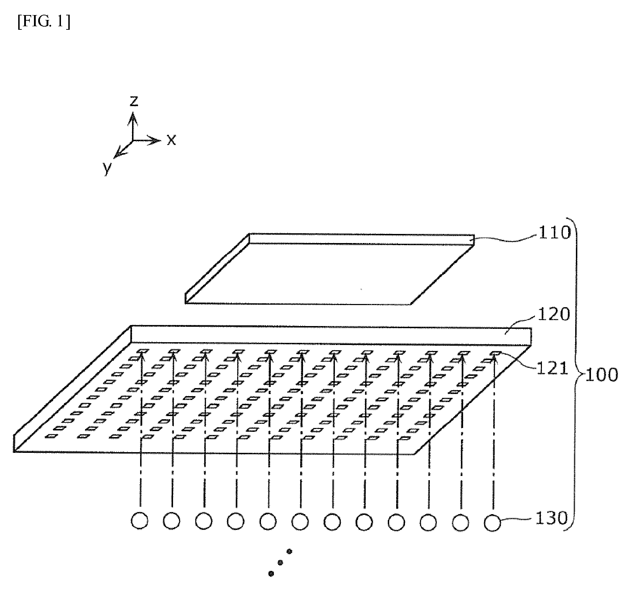

First, the overall configuration of a semiconductor package according to one or more embodiments of the invention is described using FIG. 1. FIG. 1 is an exploded perspective view of the semiconductor package according to one or more embodiments of the first example.

According to one or more embodiments as illustrated in FIG. 1, the semiconductor package 100 comprises a semiconductor chip 110 and a substrate 120 mounted on the top surface of the semiconductor chip 110, and a plurality of balls 130, formed on the back surface of the substrate 120, for connecting the substrate 120 to the external board of the semiconductor package 100. This semiconductor package 100 may be mounted on the external board using, for example, reflow.

Each component of the semiconductor package 100 according to one or more embodiments is described in detail below.

According to one or more embodiments, the semiconductor chip 110 may comprise a plurality of functions implemented by a plurality of semiconductor elements formed on, for example, a silicon circuit board. The plurality of functions is, for example, basic functions and additional functions. The semiconductor chip 110 is, for example, a television semiconductor chip expandable (that is, compatible to multiregional specifications) to many regions (for example, Japan, America, Europe and the like) and has functions corresponding to television broadcasting of each region. The above basic function is, for example, a function corresponding to frequencies shared by each region, and the above additional function is, for example, a function corresponding to the frequency unique to each region. For example, when realizing functions for a Japanese specification and a European specification by adding the functions in the Japanese specification and European specification to the function of an American specification, only the basic function of the America specification is realized while the Japanese specification and the European specification are realized by adding the additional functions to the basic function.

This type of semiconductor chip 110 may be mounted on the substrate 120 by, for example, wire bonding. The method of mounting the semiconductor chip 110 to the substrate 120 may be not limited to this, and, for example, flip chip mounting may also be used. The semiconductor chip 110 mounted on the substrate 120 may be sealed by, for example, resin, however, this resin is omitted in the illustration.

According to one or more embodiments, the substrate 120 may have the semiconductor chip 110 mounted on the top surface, and a plurality of balls 130 for connecting the semiconductor package 100 to the external board may be mounted on the back surface. That is, substrate 120 may be a relay board (interposer) that relays between the external board of the semiconductor package 100 and the semiconductor chip and is, for example, an epoxy board containing fiberglass. This substrate 120 may comprise a plurality of electrodes 121 formed on the back surface. This plurality of electrodes 121 may be disposed in a matrix on the back surface of the substrate 120 and may be electrically connected to the plurality of semiconductor elements formed on the semiconductor chip 110. In other words, the semiconductor chip 110 may be electrically connected to the external electronic components of the semiconductor package 100 through the substrate 120.

According to one or more embodiments, the plurality of electrodes 121 formed on the back surface of the substrate 120 comprise electrodes that correspond to the basic functions and electrodes that correspond to the additional functions, among the plurality of functions in the semiconductor chip 110. This will be explained hereinafter.

According to one or more embodiments, the plurality of balls 130 may be on a portion or subset of the electrodes 121 of the plurality of electrodes 121 and may be external electrodes formed on the electrodes 121 corresponding to a portion or subset of the functions among the plurality of functions of the semiconductor chip 110, and are, for example, solder balls. The plurality of balls 130 may be formed on the electrodes 121 corresponding to the basic functions of the semiconductor chip 110 and may be not formed on the electrodes 121 that correspond to the additional functions of the semiconductor chip 110. As a result, the semiconductor package 100 operates only the basic functions when the semiconductor package 100 is mounted on the external circuit board.

In this way, in the semiconductor package 100 according to one or more embodiments, the plurality of balls 130 connecting the substrate 120 to the external circuit board of the semiconductor package 100 may be on a portion of the electrodes 121 among the plurality of electrodes formed on the substrate 120 and may be formed on the electrodes 121 corresponding to the basic functions among the basic functions and the additional functions. As a result, the balls 130 are not formed on the electrodes 121 corresponding to the additional functions, therefore, when the users that use the semiconductor package 100 (for example, consumer-electronics manufacturers) do not require anything but the basic functions among the plurality of functions of the semiconductor chip 110, the printed circuit board that mounts the semiconductor package 100 can be easily designed.

### [Detailed Configuration of the Back Surface of the Semiconductor Package]

Details of the configuration of the semiconductor package 100 according to one or more embodiments as viewed from the back surface side are described below. The back surface side of the semiconductor package 100 is synonymous to the back surface side of the substrate 120.

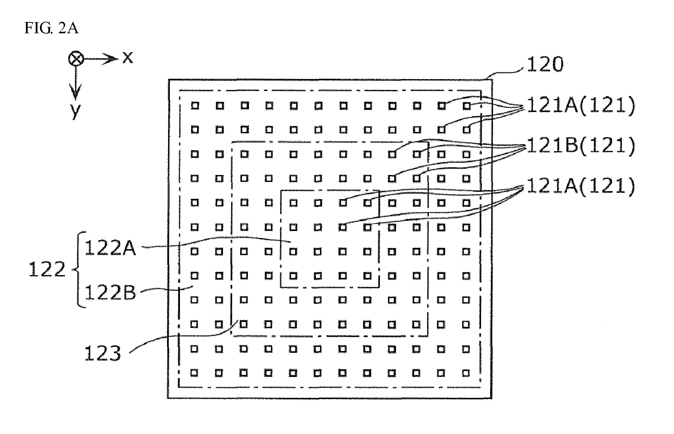

FIG. 2A is a plan diagram of the substrate 120 viewed from the back surface side before forming the plurality of balls 130.

According to one or more embodiments as illustrated in FIG. 2A, the back surface of the substrate 120 may have a basic function region 122 configured by a center region 122A that is a region of the back surface center portion and a peripheral region 122B that is the region of a back surface peripheral portion, and may have an additional function region 123, a region surrounding the center region 122A that is a region surrounded by the peripheral region 122B. The plurality of basic function electrodes 121A, which are electrodes corresponding to the basic functions of the semiconductor chip 110 among the plurality of electrodes 121, may be aggregated and disposed in the center region 122A and 122B, respectively, configuring the basic function region 122. Meanwhile, the plurality of additional function electrodes 121B, which may be electrodes corresponding to the additional functions of the semiconductor chip 110 among the plurality of electrodes 121, may be aggregated and disposed in the additional function region 123.

In this way, according to one or more embodiments, the back surface of the substrate 120 may comprise a plurality of regions (the basic function region 122 and the additional function region 123) that correspond to the plurality of functions of the semiconductor chip 110, and the plurality of electrodes 121 may be respectively formed in the corresponding region among the plurality of regions.

According to one or more embodiments, the basic function electrodes 121A disposed in the center region 122A of the back surface center portion of the substrate 120 may be electrodes corresponding to a power source or a ground for the basic functions of the semiconductor chip 110.

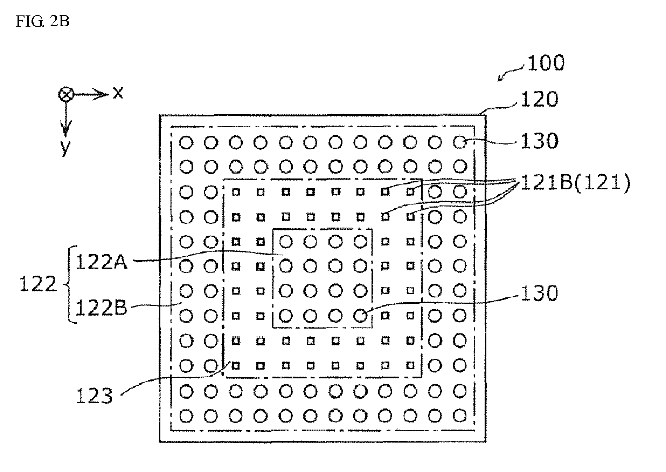

The state after the plurality of balls 130 may be formed on the substrate 120 having this type of configuration is illustrated in FIG. 2B. FIG. 2B is a plan view of the substrate 120 as viewed from the back surface side after forming the plurality of balls, according to one or more embodiments.

According to one or more embodiments as illustrated in FIG. 2B, the balls 130 may be formed on the basic function electrodes 121A and may be not formed on the additional function electrodes 121B. That is, in the state of the semiconductor package 100 as viewed from the back surface side ofthe substrate 120, the additional function electrodes 121B corresponding to the additional functions of the semiconductor chip 110 are visible.

According to one or more embodiments, the basic function electrodes 121A disposed in the center region 122A may be electrodes that correspond to power or ground for the basic functions of the semiconductor chip 110, therefore, the balls 130 formed in the center region 122A may be balls that corresponds to the power or ground for the basic functions of the semiconductor chip 110. That is, the balls 130 formed in the center region 122A are a power terminal or a ground terminal for taking power or ground for electrical components other than the semiconductor package 100 via an external substrate mounted on the semiconductor package 100.

### [External Substrate Mounted on the Semiconductor Package]

The Semiconductor package 100 according to one or more embodiments is, for example, mounted on an external substrate such as a printed circuit board. The following is a description of when the semiconductor package 100 is mounted on a printed circuit board.

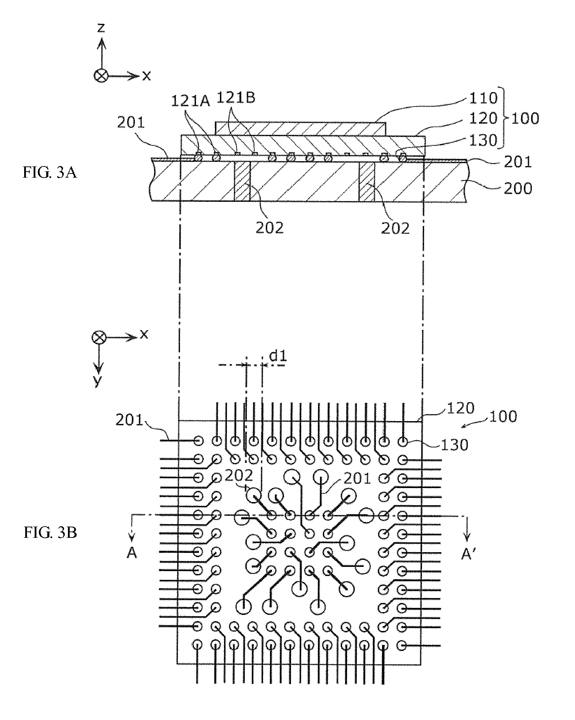

FIG. 3 is a diagram describing the semiconductor package 100 according to one or more embodiments mounted on the printed circuit board 200, and (a) is a cross-sectional view illustrating a configuration of the semiconductor package 100 mounted on the printed circuit board 200, and (b) is a diagram illustrating a connected state of when the semiconductor package 100 is mounted on the printed circuit board 200. That, (a) is a cross-sectional view of the A-A' cross section of (b), and (b) is a diagram illustrating a disposition of the balls 130 of the semiconductor package 100 relative to the wiring 201 and via holes 202 of the printed circuit board.

A configuration of the printed circuit board 200 mounted on the semiconductor package 100 is explained first.

The printed circuit board 200 according to one or more embodiments may comprise wiring 201 electrically connected to the balls 130 of the semiconductor package 100 formed on a surface layer and via holes 202, passing through the printed circuit board 200 in the thickness direction, electrically connected to the balls 130 of the semiconductor package 100 via the wiring 201.

In this type of configuration, the semiconductor package 100 operates by transmitting and receiving signals with external electrical components via the printed circuit board 200.

According to one or more embodiments as illustrated in FIG. 3, the balls 130 formed on the peripheral portion of the substrate 120 may be connected to the wiring 201 formed on the top surface of the printed circuit board 200 and from outside the mounting region of the semiconductor package 100 on the printed circuit board 200 to the balls 130. That is, the balls 130 not corresponding to the power or ground for the basic functions of the semiconductor chip 110 are connected to the wiring 201 formed on the top surface of the printed circuit board 200.

Meanwhile, according to one or more embodiments, the balls 130 formed on the back surface center portion of the substrate 120 may be connected to the via holes 202 via the wiring 201 formed on the top surface of the printed circuit board 200 (also referred to as the component surface) and on the mounting region of the semiconductor package 100 on the printed circuit board 200 and may be connected to the wiring (not illustrated) formed on the back surface (back surface of the mounting surface of the semiconductor package 100) of the printed circuit board 200. That is, the balls 130 formed in the center region 122A and corresponding to the power or ground for the basic functions of the semiconductor chip 110 may be connected to the power wiring or ground wiring formed on the back surface of the printed circuit board 200.

Here, as described above, the balls 130 may be not formed on the additional function electrodes 121B among the plurality of electrodes 121 formed on the back surface of the substrate 120. In other words, the balls 130 may be not formed in the additional function region 123.

Therefore, in the printed circuit board 200 that mounts the semiconductor package 100 according to one or more embodiments, increasing the degree of freedom of the wiring 201 for electrically connecting the balls 130 formed in the center region 122A widens the diameters of the via holes 202 for electrically connecting the balls 130 formed in the center region 122A. Accordingly, the semiconductor package 100 according to one or more embodiments simplifies the design of the printed circuit board 200 mounted on the semiconductor package 100.

According to one or more embodiments, the power wiring formed on the back surface of the printed circuit board 200 in the mounting region of the semiconductor package 100 on the printed circuit board 200 may connect to the power wiring of the component surface of the printed circuit board 200 by the via holes (not shown on the diagram) used for the power source. Furthermore, the printed circuit board 200 may have an electrically connected, multilayer structure comprising a power layer and a ground layer, each of which may be an inner layer of the printed circuit board 200. The balls 130 corresponding to the power for the basic functions in the semiconductor chip 110 may be connected to the power layer by the non-through via holes, and the balls 130 corresponding to the ground of the basic functions of the semiconductor chip 110 may be connected to the ground layer by the non-through via holes.

The following is a description, using the semiconductor package according to a comparative example of the first example, of one effect achieved by the semiconductor package 100 according to one or more embodiments and a reason why the design of the mounted printed circuit board 200 can be simplified.

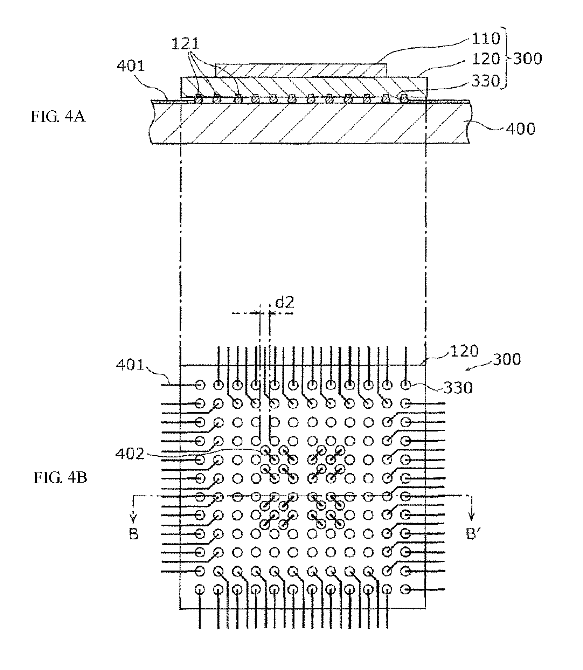

FIG. 4 is a diagram describing a semiconductor package 300 according to one or more embodiments of the comparative example of the first example mounted on the printed circuit board 400, and (a) is a cross-sectional view illustrating a configuration of the semiconductor package mounted on a printed circuit board 400, and (b) is a diagram illustrating a connected state of when the semiconductor package 300 is mounted on the printed circuit board 400. That, (a) is a cross-sectional view of the B-B' cross section of (b), and (b) is a diagram illustrating a disposition of the balls 330 of the semiconductor package 300 relative to the wiring 401 and via holes 402 of the printed circuit board 400.

The semiconductor package 300 illustrated in the same drawing may have a similar configuration as the semiconductor package 100 according to one or more embodiments of the first example except with respect to the point that the balls 330 formed in each of the electrodes 121 of the substrate 120 may be different. That is, the semiconductor package 300 according to the comparative example comprises a plurality of balls 330 formed on the top of the basic function electrodes 121A and the top of the additional function electrodes 121B.

Therefore, on the printed circuit board 400 mounted on the semiconductor package 300 of the comparative example, there is little degree of freedom for the wiring 401 for connecting the balls 330 disposed on the top of the basic function electrodes 121A and the via holes 402. There is little degree of freedom to connect the balls 330 corresponding to power or ground for the basic functions of the semiconductor chip 110 disposed in the center region 122A of the substrate 120. This is described in further detail hereinafter.

When the semiconductor package 300 only operates the basic functions, the balls 330 formed on the additional function electrodes 121B are not used to realize the basic functions. That is, they may be unused balls, in other words, they may be wasteful balls not relating to the operation of the semiconductor package 300. Therefore, in this situation, the balls 330 formed on the additional function electrodes 121B do not connect. Nevertheless, there is a need for the via holes 402 and the wiring 401 connecting the balls 330 of the back surface center portion (center region 122A) of the semiconductor package 300 to be formed to avoid this. Specifically, a designer of the printed circuit board 400 is required to design the via holes 402 and wiring 401 for the connection of the holes 330 of the center region 122A so as not to contact the balls 330 formed on the additional function electrodes 121B when designing the printed circuit board 400.

By this, with the printed circuit board 400 mounted by the semiconductor package 300 of the comparative example, constraints arise in the pattern width (wiring width) of the wiring 401 connecting the balls 330 formed on the center region 122A and the dimension of the via holes 402 (diameter of the via holes). That is, there is a need to decrease the size of the pattern width of the wiring 401 and the size of the via holes 402. Specifically, if the diameter of the via holes 202 in the first example are d1 and the diameter of the via holes 402 in the comparative example of the first example are d2, then d1>d2.

The following phenomenon may occur when the wiring 401 with a narrow pattern width and the via holes 402 with small diameters may be designed in this manner.

Generally, the smaller are the diameters of the via holes 402, the higher is the cost of the printed circuit board 400. This is on account that drill bits are being easily broken due to the thin drill bits used to form the via holes 402 with a small diameter and on account of the need to slow the speed used to drill the hole. In the manufacturing process of the printed circuit board 400, when the speed of drilling holes is slower than normal, unnecessary time is spent above normal, thereby increasing the cost of the printed circuit board 400.

Furthermore, when the diameter of the via holes 402 is small and a large current flows through these via holes 402, the surface that assures the performance of the printed circuit board 400 is disadvantageous. This is because impedance easily increases due to the via holes 402 with a small diameter causing a large voltage drop when a large current flows.

Therefore, the printed circuit board 400 formed with the wiring 401 with the narrow pattern width and the via holes 402 with the small diameter may become costly and ensuring performance becomes difficult.

Particularly, as mentioned above, the balls 330 disposed in the center region 122A of the substrate 120 correspond to power or ground for the basic functions of the semiconductor chip 110. Therefore, the wiring 401 and via holes 402 connecting the balls 330 disposed in the center region 122A must distribute a large current, and it is important to increase the pattern width of the wiring 401 and the diameter of the via holes 402 to ensure performance.

Nevertheless, as mentioned above, with the printed circuit board 400 on which the semiconductor package 300 may be mounted according to the comparative example, there is a need for the via holes 402 and the wiring 401 connecting the balls 330 formed in the center region 122A to be disposed to avoid the balls 330 formed on the additional function electrodes 121B. For this reason, it is not easy to enlarge the diameters of the via holes 402 connecting the balls 330 formed in the center region 122A or widen the pattern width of the wiring 401.

Furthermore, in order to assure performance, a bypass capacitor may be disposed on the back surface nearest the via holes 402 connecting the holes 330 formed in the center region 122A which may be the holes 330 corresponding to power or ground, and to have the wiring 401 connecting the balls 330 and via holes 402 in a short and wide pattern.

Nevertheless, when there are constraints on the via holes 402, then the size and number of usable bypass capacitors are susceptible to limitation thus increasing the degree of difficulty to ensure performance. There is a need for the via holes 402 to be disposed to avoid the balls 330. Nevertheless, the via holes 402 cannot be disposed freely in the additional function region 123 because of the balls 330 formed on the additional function electrodes 121B. Therefore, the size and number of bypass capacitors disposed on the back surface of the printed circuit board 400 may be limited. As a result, it is difficult to ensure the performance of the semiconductor package 300 mounted on the printed circuit board 400.

As above, the semiconductor package 300 according to the comparative example of the first example brings about an increase in cost of the mounted printed circuit board 400 and makes it difficult to design a printed circuit board 400 that can ensure performance because the balls 330 are formed on all of the electrodes 121.

In contrast, with the printed circuit board 200 on which the semiconductor package 100 may be mounted according to one or more embodiments, the pattern width of the wiring 201 and diameter of the via holes 202 to connect the balls 130 formed in the center region 122A can be enlarged because there are no balls formed on the additional function electrodes 121B. As a result, it is easy to decrease cost and ensure the performance of the printed circuit board 200.

Specifically, with the semiconductor package 100 according to one or more embodiments of the first example, there are no balls 130 formed in the additional function region 123. As a result, with the printed circuit board 200 on which the semiconductor package 100 may be mounted according to one or more embodiments of the first example, there is no need to dispose the via holes 202 and the wiring 201 connected to the balls 130 formed in the center region 122A to avoid the balls formed on the additional function electrodes 121B.

Therefore, according to one or more embodiments, it becomes possible to enlarge the diameters of the via holes 202 and widen the pattern width of the wiring 201 connected to the balls 130 formed in the center region 122A. As a result, compared to the printed circuit board 400 in the comparative example, a wide drill to form the via holes 202 can be used, and the cost of the printed circuit board 200 is decreased.

Furthermore, compared to the printed circuit board 400 in the comparative example, by enlarging the diameters of the via holes 202 the impedance is decreased, voltage drop is reduced, and performance of the printed circuit board 200 is easily ensured.

Furthermore, according to one or more embodiments, the via holes 202 connecting the balls 130 formed in the center region 122A which are the balls 130 corresponding to the power or ground can be disposed freely in the additional function region 123. Therefore, the bypass capacitors may be disposed on the back surface nearest these via holes 202. As a result, the size and number of bypass capacitors disposed on the back surface of the printed circuit board 200 are not limited. Furthermore, the performance of the semiconductor package 100 mounted on the printed circuit board 200 is easily ensured.

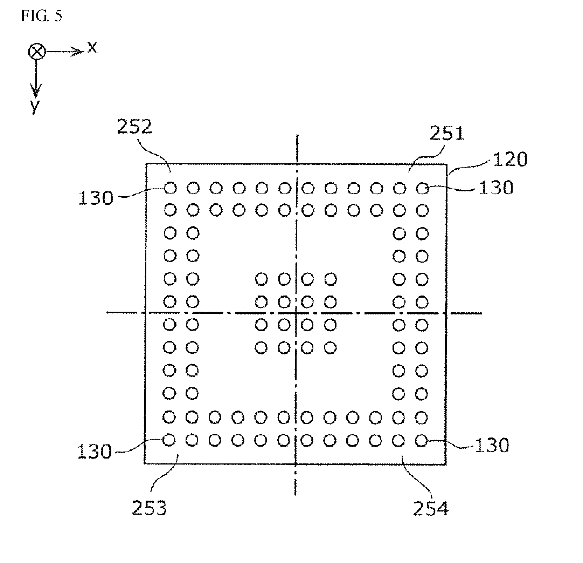

Furthermore, according to one or more embodiments as illustrated in FIG. 5, the plurality of balls 130 can be disposed on the back surface of the substrate 120 without deviation. Here, FIG. 5 is a diagram describing the disposition of the plurality of balls 130 formed on the substrate 120.

According to one or more embodiments as illustrated in the same drawing, a shape of the substrate as viewed from a direction perpendicular to the back surface may be substantially rectangular, and when each region of the substrate 120 divided by the line segments that connect the center of the substantially rectangular shape to midpoints of each side that configure the substantially rectangular shape may be a quadrant, the number of the plurality of balls 130 disposed in each quadrant may be essentially the same. Specifically, according to one or more embodiments as illustrated in FIG. 5, the substrate 120 may be divided into four quadrants: a first quadrant 251, a second quadrant 252, a third quadrant 253, and a fourth quadrant 254. In this case, the number of balls 130 disposed in the first quadrant 251, the number of balls 130 disposed in the second quadrant 252, the number of balls 130 disposed in the third quadrant 253, and the number of balls 130 disposed in the fourth quadrant 254 may be equal. Equal means, for example, the difference in the number of balls 130 disposed in each quadrant may be within 10 percent, within five percent if precise, and within three percent if more precise.

As a result, the semiconductor package 100 can be prevented from slanting when mounting the semiconductor package 100 to the printed circuit board 200.

### [Effect]

As above, in the semiconductor package 100 according to one or more embodiments, the plurality ofballs 130 for connecting the substrate 120 to the external substrate ofthe semiconductor package 100 may be on a portion of the electrodes 121 among the plurality of electrodes 121 formed on the substrate 120 and may be formed on the electrodes 121 that correspond to the basic functions among the basic functions and additional functions (that is, on the basic function electrodes 121A).

According to one or more embodiments, the semiconductor package 100 can operate by a portion of the functions (basic functions) among the plurality of functions and can reduce the occurrence of wasteful balls unrelated to operation by using the semiconductor chip 110 that can operate by a plurality of functions and the substrate 120 to operate the semiconductor chip 110 by a plurality of functions (basic functions and additional functions).

According to one or more embodiments, the balls 130 may be not formed on the electrodes 121 corresponding to the additional functions, therefore, users (for example, consumer electronics manufacturers) that use the semiconductor package 100 can easily design a printed circuit board that mounts the semiconductor package 100 when only the basic functions among the plurality of functions in the semiconductor chip 110 are needed.

According to one or more embodiments, manufacturers that produce the semiconductor package 100 (for example, semiconductor component manufacturers) can realize a semiconductor package that operates by only a portion of the functions rather than newly designing and producing a semiconductor chip that may have only a portion of the functions among the plurality of functions in the semiconductor chip 110.

According to one or more embodiments, manufacturers that produce the semiconductor package 100 can realize a semiconductor package operated by only a portion of the functions rather than newly designing and producing a substrate for operating the semiconductor chip 110 having a plurality of functions by only a portion of the functions. Specifically, a semiconductor package 100 that operates only by a portion of the functions can be realized by not forming balls on the additional function electrodes 121B among the electrodes formed on the substrate 120 (basic function electrodes 121A and additional function electrodes 121B). In other words, a semiconductor package that operates by only a portion of the functions can be realized rather than designing and producing a substrate that may comprise basic function electrodes 121Athat correspond to a portion of the functions among the plurality of functions and does not have additional electrodes 121B that correspond to the other functions. That is, regardless of the functions the user uses among the plurality of functions, one type of substrate 120 may be designed, and there is no need to design and produce a substrate for each function the user uses. That is, the operations of the semiconductor package may be switched depending on whether or not balls may be formed on the additional function electrodes 121B. Therefore, the design production cost is reduced.

Furthermore, with the semiconductor package 100 according to one or more embodiments of the present invention, the number of the plurality of balls 130 disposed in the first quadrant 251, the second quadrant 252, the third quadrant 253, and the second quadrant 254 are essentially equal. By this, the semiconductor package 100 can be prevented from slanting when mounting the semiconductor package 100 to the printed circuit board 200.

### [Second example]

Next, a semiconductor package is described according to one or more embodiments of a second example.

The semiconductor package 500 according to one or more embodiments of the second example may be substantially similar as the semiconductor package 100 according to one or more embodiments of the first example, but the plurality of electrodes that correspond respectively to the basic functions among the plurality of electrodes formed on the substrate differ with respect to the point that they may be disposed in a zigzag pattern. That is, the plurality of balls differs with respect to the point that they may be disposed in a zigzag pattern. That, in each embodiment illustrated hereinafter, components which are substantially the same as in the first example above have the same reference numbers and the description thereof may be omitted.

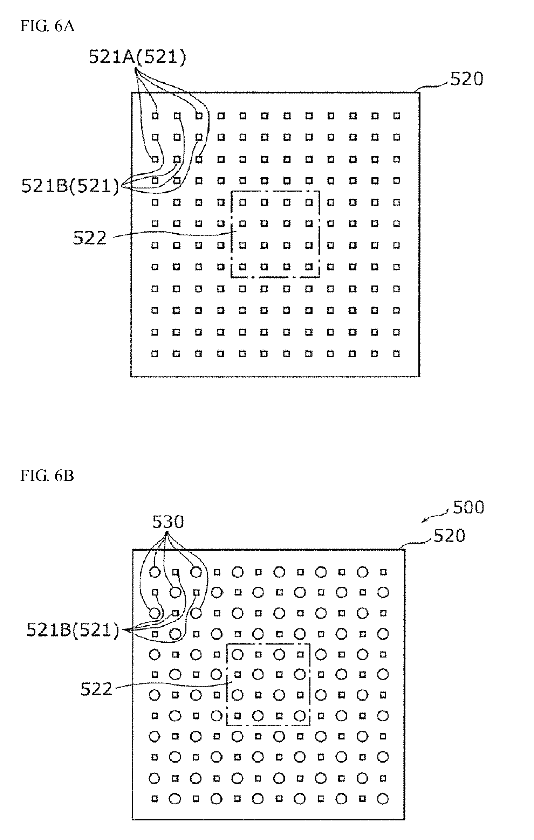

FIG. 6A is a plan view of a substrate as viewed from the back surface side before the plurality of balls being formed on the semiconductor package according to one or more embodiments of a second example.

According to one or more embodiments as illustrated in FIG. 6A, the back surface of a substrate 520 may have a center region 522 which is a region of the center portion of the back surface, and a plurality of electrodes 521 may be formed including a plurality of basic function electrodes 521A which are electrodes corresponding to the basic functions and a plurality of additional function electrodes 521B that correspond to the additional functions among the plurality of functions that the semiconductor chip 110 may have.

According to one or more embodiments, on the back surface of the substrate 520 the plurality of basic function electrodes 521A are respectively disposed in a zigzag pattern and the plurality of additional function electrodes 521B are respectively disposed adjacent to one or all of the basic function electrodes 521A. In other words, the plurality of basic function electrodes 521A and the plurality of additional function electrodes 521B are disposed in a distributed manner.

According to one or more embodiments, the basic function electrodes 521A among the plurality of electrodes 521 formed in this center region 522 may be electrodes that correspond to power or a ground for the basic functions in the semiconductor chip 110. Furthermore, the additional function electrodes 521B among the plurality of electrodes 521 formed in the center region 522 may be electrodes corresponding to power or ground for the additional functions in the semiconductor chip 110.

According to one or more embodiments, the state after a plurality of balls 530 may be formed on the substrate 520 having this type of configuration is illustrated in FIG. 6B. FIG. 6B is a plan view of the substrate 520 after the plurality of balls 530 may be formed as viewed from the back surface side.

As described above, the plurality of basic function electrodes 521A corresponding respectively to the basic functions in the semiconductor chip 110 may be disposed in a zigzag pattern and the balls 530 may be formed on the basic function electrodes 521A. Therefore, according to one or more embodiments as illustrated in FIG. 6B, when the semiconductor package 500 may be viewed from the back surface side, the plurality of balls 530 may be respectively disposed in the zigzag pattern, and the plurality of additional function electrodes 521B may be respectively seen to be disposed between the plurality of balls 530 disposed in the zigzag pattern.

In this way, with the semiconductor package 500 according to one or more embodiments of the present invention, the plurality of electrodes (basic function electrodes 521A) corresponding respectively to a portion of the functions (basic functions) among the plurality of electrodes 521 may be disposed in a zigzag pattern. By this, the semiconductor package 500 can be prevented from slanting when mounting the semiconductor package 500 to the printed circuit board. Furthermore, the stress on the substrate 520 can be distributed and failure of the semiconductor package 500 from the deflection of the substrate 520 can be reduced.

The following is a description of the configuration when the semiconductor package 500 is mounted on the printed circuit board according to one or more embodiments.

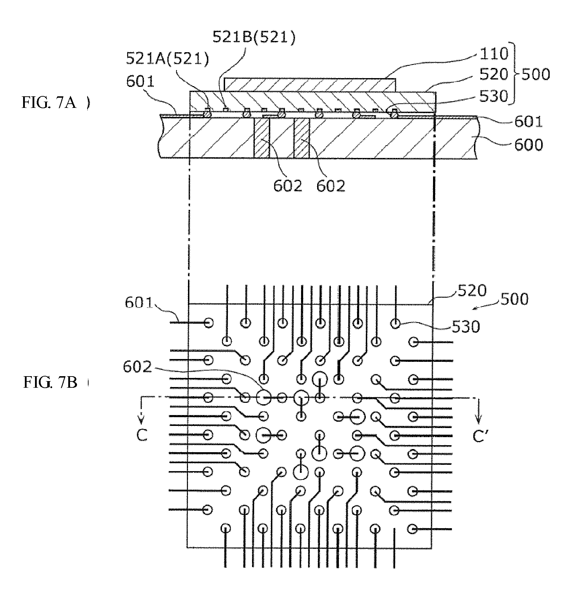

FIG. 7 is a diagram describing the semiconductor package 500 mounted on a printed circuit board 600 according to one or more embodiments, and (a) is a cross-sectional view illustrating a configuration of the semiconductor package 500 mounted on the printed circuit board 600, and (b) is a diagram illustrating a connected state of when the semiconductor package 500 is mounted on the printed circuit board 600. That, (a) is a cross-sectional view of the C-C' cross section of (b), and (b) is a diagram illustrating a disposition of the balls 530 of the semiconductor package 500 relative to the wiring 601 and via holes 602 of the printed circuit board 600.

According to one or more embodiments as illustrated in (a) of FIG. 7, in the semiconductor package 500, by not having balls 530 formed on the additional function electrodes 521B of the semiconductor chip 110 among the plurality of electrodes 521, the substrate 520 achieves a similar effect to that of the semiconductor package 100 according to one or more embodiments of the first example. That is, the pattern width of the wiring 601 and the diameter of the via holes 602 to connect the balls 530 formed in the center region 522 can be enlarged. By this, it is easy to decrease cost and ensure the performance of the printed circuit board 600. Furthermore, the design of the printed circuit board 600 mounted on the semiconductor package 500 according to one or more embodiments of the second example is simplified.

The following is a description, using the semiconductor package according to a comparative example of the second example, of one effect achieved by the semiconductor package 500 according to one or more embodiments and a reason why the design of the mounted printed circuit board 600 can be simplified.

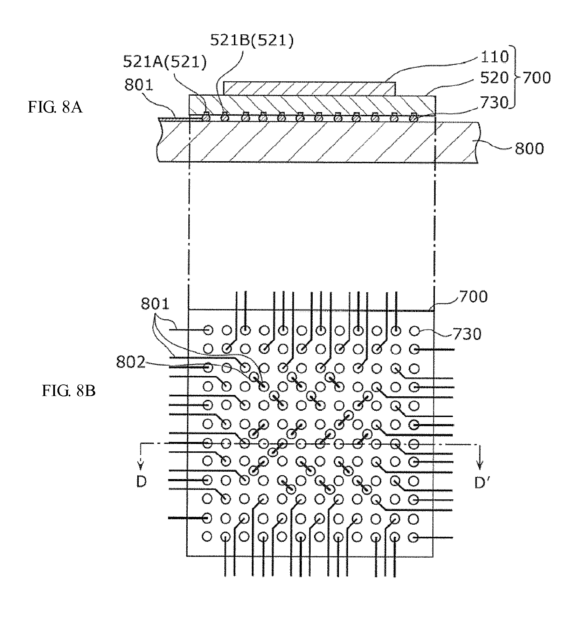

FIG. 8 is a diagram describing the semiconductor package 700 according to the comparative example of the second example mounted on a printed circuit board 800, and (a) is a cross-sectional view illustrating a configuration of the semiconductor package 700 mounted on the printed circuit board 800, and (b) is a diagram illustrating a connected state of when the semiconductor package 700 is mounted on the printed circuit board 800. That, (a) is a cross-sectional view of the D-D' cross section of (b), and (b) is a diagram illustrating a disposition of the balls 730 of the semiconductor package 700 relative to the wiring 801 and via holes 802 of the printed circuit board 800.

The semiconductor package 700 illustrated in the same drawing may have a similar configuration as the semiconductor package 500 according to one or more embodiments of the second example, except with respect to the point that the balls 730 formed on each of the electrodes 521 of the substrate 520 may be different.

Therefore, with the printed circuit board 800 mounted on the semiconductor package 700 according to the comparative example of the second example, as in the semiconductor package 300 according to the comparative example of the first example, the wiring 801 and the via holes 802 to connect the balls 730 disposed on the basic function electrodes 521A must be disposed such that they do not contact the balls 730 formed on the additional function electrodes 521B.

By this, with the printed circuit board 400 on which the semiconductor package 700 may be mounted according to the comparative example of the first example, constraints arise in the pattern width (wiring width) of the wiring 801 and in the dimension of the via holes 802 (diameter of the via holes) connecting the balls 730 formed on the center region 522. That is, there is a need to decrease the size of the pattern width of the wiring 801 and the size of the via holes 802. In other words, the degree of freedom connecting the balls 730 corresponding to power or ground for the basic functions in the semiconductor chip 110 gets smaller. Alternatively stated, the semiconductor package 700 according to the comparative example of the second example brings about an increase in cost of the mounted printed circuit board 800 and makes it difficult to design the printed circuit board 800 that can ensure performance because the balls 730 may be formed on all of the electrodes 521, similar to the semiconductor package 300 according to the comparative example of the first example.

In contrast, by not having balls 530 formed on the additional function electrodes 521B, the printed circuit board 600 mounted on the semiconductor package 500 according to one or more embodiments achieves a similar effect to that of the semiconductor package 100 according to one or more embodiments of the first example. That is, the pattern width of the wiring 601 and diameter of the via holes 602 to connect the balls 530 formed in the center region 522A can be enlarged. As a result, it is easy to decrease cost and ensure the performance of the printed circuit board 600.

As above, in the semiconductor package 500 according to one or more embodiments, the plurality of balls 530 for connecting the substrate 520 to the external substrate of the semiconductor package 500 may be formed on the basic function electrodes 521A among the plurality of electrodes 521 formed on the substrate 520.

By this, the semiconductor package 500 according to one or more embodiments achieves a similar effect as the semiconductor package 100 according to one or more embodiments of the first example. That is, the semiconductor package 500 can operate by a portion of the functions among the plurality of functions (basic functions) and can reduce the occurrence of wasteful balls unrelated to operation by using the semiconductor chip 110 that can operate by a plurality of functions and the substrate 120 to operate the semiconductor chip 110 by a plurality of functions (basic functions and additional functions). The pattern width of the wiring 601 and diameter of the via holes 602 to connect the balls 530 formed in the center region 522A can be enlarged. By this, it is easy to decrease cost and ensure the performance of the printed circuit board 600. Furthermore, the design of the printed circuit board 600 on which the semiconductor package 500 may be mounted according to one or more embodiments of the second example may be simplified.

That is, when the plurality of basic function electrodes 521A and the plurality of additional function electrodes 521B may be displaced in a distributed manner among each function according to one or more embodiments as illustrated in the second example, and when the plurality of basic function electrodes 121A and the plurality of additional function electrodes 121B may be disposed in an aggregated manner among each function, a similar effect is achieved. As a result, the size increases as the number of electrodes where balls may be not formed increases. Furthermore, there is a greater effect for the number of electrodes where balls are not formed than for the disposition of electrodes where balls are not formed.

Furthermore, in one or more embodiments, among the plurality of electrodes 521 formed on the back surface of the substrate 520, the plurality of basic function electrodes 521A are respectively disposed in a zigzag pattern, and the plurality of additional function electrodes 521B are respectively disposed adjacent to any one of the basic function electrodes 521A.

By this, the semiconductor package 500 according to one or more embodiments reduces slanting of the semiconductor package 500 during mounting more than the semiconductor package 100 according to one or more embodiments of the first example. Furthermore, the stress on the substrate 520 can be distributed thereby reducing failure of the semiconductor package 500 due to the deflection by the substrate 520.

### [Third example]

Next, a semiconductor package is described according to one or more embodiments of a third example.

The semiconductor package according to one or more embodiments comprises a semiconductor chip that may have basic functions, which are functions the semiconductor chip may have from the initial production of the semiconductor component manufacturer, and additional functions, which are functions that are additional based on the specification change after the initial production of the semiconductor component manufacturer. The basic functions are, for example, the functions of American specifications, and the additional functions correspond to the additional functions in the first and second examples, for example, the functions of Japanese specifications and European specifications. That is, a semiconductor chip in the semiconductor package according to one or more embodiments may comprise a plurality of functions based on the specification change after the initial production.

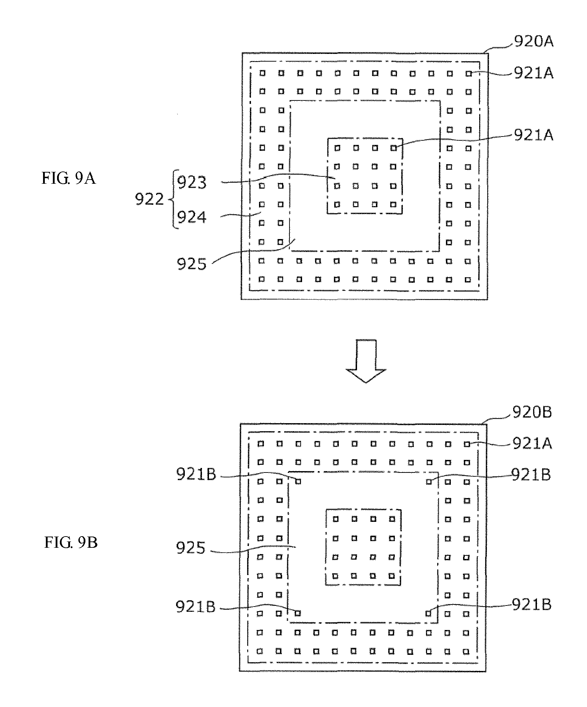

FIG. 9 is a diagram describing the semiconductor package according to one or more embodiments of the third example, and (a) is a plan view of a substrate where a semiconductor chip is mounted as viewed from the back side surface before a specification change, and (b) is a plan view of the substrate where a semiconductor chip is mounted as viewed from the back side surface after the specification change.

According to one or more embodiments as illustrated in (a) of FIG. 9, before a specification change of the semiconductor chip, the substrate 920A on which the semiconductor chip may be mounted may have a basic function region 922 which is a region formed with basic function electrodes 921A that correspond to the basic functions. This basic function region 922 is configured of a center region 923 which is a region of the back surface center portion of the substrate 920A and a peripheral region 924 which is a region of the peripheral back surface. The substrate 920A also may have an additional function region 925 where the basic function electrodes 921A are not formed, and this additional function region 925 encompasses the center region 923 and may be encompassed by the peripheral region 924.

According to one or more embodiments, a semiconductor package such as this comprising the substrate 920A can operate by the basic functions by having balls formed on all of the basic function electrodes 921A.

Next, description is given of a configuration of a semiconductor package of when the specification of the above semiconductor chip is a specification that has the basic functions and the additional functions according to a specification change from the semiconductor component manufacturer.

According to one or more embodiments as illustrated in (b) of FIG. 9, after a specification change of the semiconductor chip, the substrate 920B on which the semiconductor chip may be mounted comprises additional function electrodes 921B in the additional function region 925 compared to the substrate 920 before the specification change of the semiconductor chip. These additional function electrodes 921B are electrodes that correspond to the additional functions added during the specification change of the semiconductor chip.

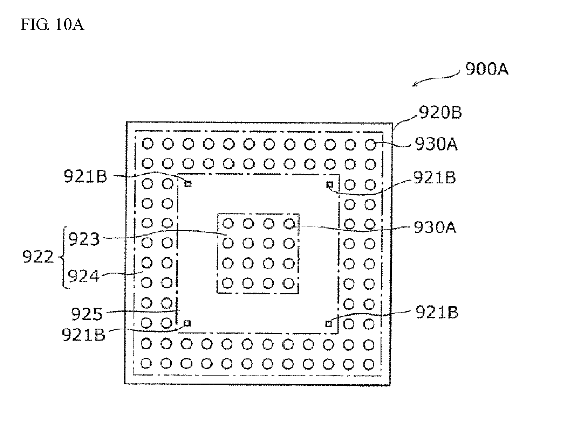

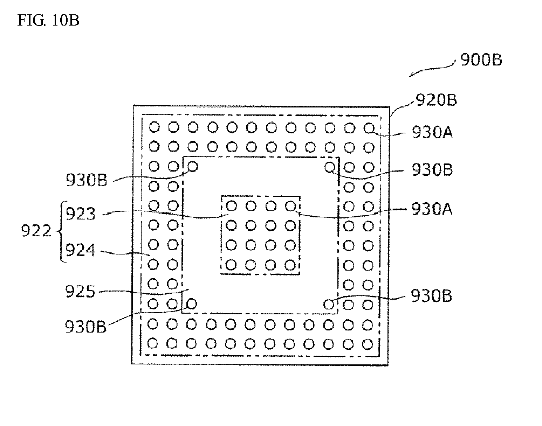

According to one or more embodiments, a semiconductor package having this type of substrate 920B is produced as a semiconductor package that can operate by only basic functions or a semiconductor package that can operate by the basic functions and the additional functions depending on whether or not balls may be formed on the additional function electrodes 921B. This is described using FIG. 10A and FIG. 10B. FIG. 10A is a plan view of a semiconductor package that can operate by only basic functions as viewed from the back surface side of the substrate, and FIG. 10B is a plan view of a semiconductor package that can operate by the basic functions and the additional functions as viewed from the back surface side of the substrate.

According to one or more embodiments, the semiconductor package 900A illustrated in FIG. 10A comprises a semiconductor chip that has basic functions and additional functions and a substrate 920B, and balls 930A are formed on all of the basic function electrodes 921A, and because balls are not formed on any of the additional function electrodes 921B, the basic functions can operate and the additional functions will not operate.

According to one or more embodiments, in a configuration comprising a semiconductor chip that has basic functions and additional functions and a substrate 920 similar to this type of semiconductor package 900A, because the semiconductor package 900B illustrated in FIG. 10B has balls 930B formed on all of the basic function electrodes 921A and all of the additional function electrodes 921B, basic functions and additional functions can operate.

According to one or more embodiments, after the specification change of the semiconductor chip, a semiconductor package 900A that has only the functions (basic functions) of the semiconductor chip before the specification change and a semiconductor package 900B that has the functions (basic functions and additional functions) of the semiconductor chip after the specification change are realized without using the semiconductor chip prior to the specification change.

In other words, according to one or more embodiments, the semiconductor component manufacturer does not continuously produce the semiconductor chip and the substrate 920A before the specification change, but realizes the semiconductor package 900A that has only the functions (basic functions) of the semiconductor chip before the specification change by not having balls 930 formed on the additional function electrodes 921B using the semiconductor chip and substrate 920A after the specification change. That is, the semiconductor component manufacturer can reduce the cost of manufacturing and reduce inventory of the semiconductor chip and the substrate 920A before the specification change.

As above, in one or more embodiments, when the user (for example, a consumer electronics manufacturer) does not require additional functions after the specification change of the semiconductor chip, the plurality of balls 930A and 930B for connecting the substrate to the external circuit board are formed on the basic function electrodes 921A among the plurality of electrodes (basic function electrodes 921A and additional function electrodes 921B) formed on the substrate 920B. That is, a semiconductor component manufacturer produces the semiconductor package 900A where balls 930B are not formed on the additional function electrodes 921B.

This type of semiconductor package 900A can achieve a similar effect to the semiconductor package 100 according to one or more embodiments of the first example. That is, the semiconductor package uses a semiconductor chip that can operate by the plurality of functions and the substrate 920B to operate the semiconductor chip by the plurality of functions (basic functions and additional functions) and can operate by a portion of the functions (basic functions) among the plurality of functions to thereby reduces the occurrence of wasteful balls unrelated to operation. Furthermore, the pattern width of the wiring and diameter of the via holes to connect the balls 930A formed in the center region 923A can be enlarged. By this, it is easy to decrease cost and ensure the performance of the printed circuit board which mounts the semiconductor package 900A. Furthermore, design of the printed circuit board may be simplified.

According to one or more embodiments, when adding functions of the semiconductor chip, a semiconductor component manufacturer can dispose additional function electrodes 921B in the additional function region 925 and provide semiconductor packages 900A in a state excluding the balls 930B on the additional function electrodes 921B for users that do not require the additional functions and provide semiconductor packages 900B in a state comprising balls 930B on the additional functions electrodes 921B for users that require the additional functions.

According to one or more embodiments, a semiconductor component manufacturer can unify the production of the additional function version of the semiconductor chip and the substrate 920B, providing both forms of semiconductor packages (basic function version of the semiconductor package 900A and additional function version of the semiconductor package 900B).

According to one or more embodiments, the disposition of the plurality of basic function electrodes 921A on the substrate 920A where the semiconductor chip may be mounted before the specification change and the disposition of the plurality of basic function electrodes 921A on the substrate 920B where the semiconductor chip may be mounted after the specification change may be the same.

According to one or more embodiments, users that do not require the additional functions after the specification change of the semiconductor chip, among the users that use the semiconductor chip comprising the semiconductor chip before the specification change of the semiconductor chip, are not required to redesign the printed circuit board. Specifically, a semiconductor component manufacturer can offer the semiconductor package 900A in a state excluding the balls 930B on the additional function electrodes 921B for users that do not require additional functions after the specification change to the semiconductor chip. By this, users are not required to design a substrate that avoids balls formed on additional function electrodes 921B. In other words, the semiconductor package 900A after the specification change can be mounted using the printed circuit board that is the same as the printed circuit board that mounts the semiconductor package before the specification change. That is, there is no need to redesign the printed circuit board.

### [Fourth example]

Next, a semiconductor package is described according to one or more embodiments of a fourth example.

In a semiconductor package according to one or more embodiments, a substrate has evaluation electrodes to evaluate the semiconductor package formed on the back surface. By this, the semiconductor component manufacturer evaluates the semiconductor package by forming balls on the evaluation electrodes on the evaluation semiconductor package but does not have to publish the existence of the evaluation balls to the user by not forming balls on the evaluation electrodes on the semiconductor package shipped to the user.

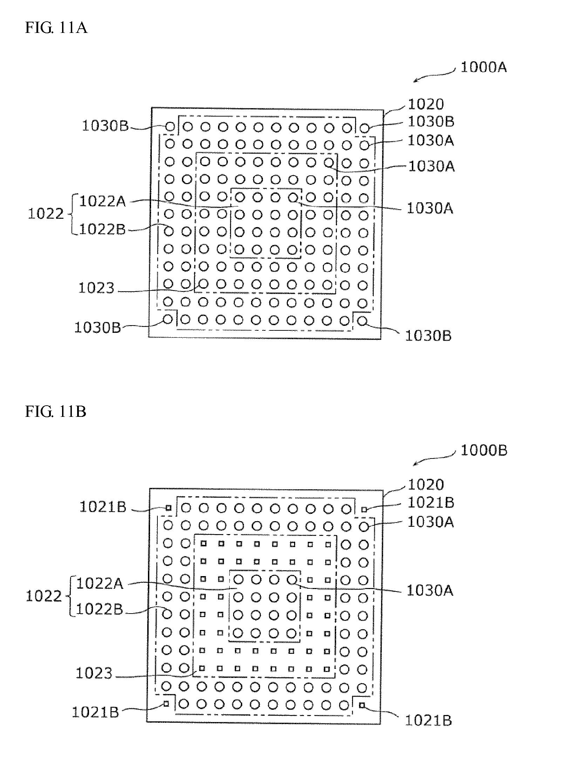

FIG. 11A is a plan view of the semiconductor package at the time of evaluation by the semiconductor component manufacturer as viewed from the back surface side of the substrate in one or more embodiments, and FIG. 11B is a plan view of the semiconductor package at the time of shipping from the semiconductor component manufacturer as viewed from the back surface side of the substrate in one or more embodiments.

According to one or more embodiments, the semiconductor package 1000A illustrated in FIG. 11A and the semiconductor package 1000B illustrated in FIG. 11B have the same semiconductor chip and the same substrate 1020. The back surface of the substrate 1020 has a basic function region 1022 configured by a center region 1022A that is a region of the back surface center portion and a peripheral region 1022B, and has an additional function region 1023, a region surrounding the center region 1022A that is a region surrounded by the peripheral region 1022B similar to the first example. A plurality of basic function electrodes that are electrodes corresponding to basic functions of the semiconductor chip are disposed in an aggregated manner in respective center regions 1022A and 1022B that configure the basic function region 1022. Meanwhile, a plurality of additional function electrodes that are electrodes corresponding to additional functions of the semiconductor chip are disposed in an aggregated manner in the additional function region 1023.

However, according to one or more embodiments as illustrated in FIG. 11A and FIG. 11B, the peripheral region 1022B may be cut away on the corners (four corners) of the substrate 1020. Evaluation electrodes 1021B may be formed in the places that are cut away according to one or more embodiments as illustrated in FIG. 11B.

A semiconductor component manufacturer forms balls 1030B on these evaluation electrodes 1021B at the time of evaluation according to one or more embodiments as illustrated in FIG. 11A. That is, a semiconductor component manufacturer forma balls 1030A and 1030B on all electrodes (the basic function electrodes, the additional function electrodes, and the evaluation electrodes 1021B) at the time of evaluation of the semiconductor package 1000A. By this, the semiconductor component manufacturer can evaluate, for example, the semiconductor package 1000A in such ways as the evaluation of the semiconductor chip and the connection reliability of the semiconductor chip to the substrate 1020.

According to one or more embodiments, the semiconductor component manufacturer does not have to publish the existence of the evaluation balls 1030B to the user by shipping without forming balls 1030B on the evaluation electrodes 1021B. The semiconductor package 1000B illustrated in FIG. 11B that has balls 1030A formed on the basic function electrodes and does not have balls 1030A, 1030B formed on the additional function electrodes or the evaluation electrodes 1021B may be shipped to users that do not require the additional functions. Conversely, the semiconductor package that has balls 1030A formed on the basic function electrodes and the additional function electrodes and does not have balls 1030B formed on the evaluation electrodes 1021B may be shipped to users that require the additional functions.

As above, the substrate 1020 has evaluation electrodes 1021B formed on the back surface in one or more embodiments.

According to one or more embodiments, evaluation may be done by forming evaluation balls 1030A on the evaluation electrodes 1021B at the time of evaluation, but in the final product shipped to the user a form excluding these balls 1030A can be offered. Therefore, they may be used without publishing the existence of the evaluation balls 1030A to the user.

According to one or more embodiments, in semiconductor packages 1000B shipped to users that do not require the additional functions, the plurality of balls 1030A connecting the substrate 1020 to the external substrate of the semiconductor package 1000B are formed on the basic function electrodes among the plurality of electrodes (the basic function electrodes, the additional function electrodes, and the evaluation electrodes 1021B) formed on the substrate 1020.

By this, the semiconductor package 1000B achieves a similar effect to the semiconductor package 100 according to one or more embodiments of the first example. That is, the semiconductor package 1000B uses a semiconductor chip that can operate by the plurality of functions and the substrate 1020 to operate the semiconductor chip by the plurality of functions (basic functions and additional functions) and can operate by a portion of the functions (basic functions) among the plurality of functions thereby reducing the occurrence of wasteful balls unrelated to operation. Furthermore, the pattern width of the wiring and diameter of the via holes to connect the balls 1030A formed in the center region 1022A can be enlarged. By this, it is easy to decrease cost and ensure the performance of the printed circuit board on which the semiconductor package 1000B may be mounted. Furthermore, design of the printed circuit board may be simplified.

### [Other]

Semiconductor packages according to embodiments of the present invention are described above, but the present invention is not limited to these embodiments.

For example, in the first, second, and fourth examples above, the plurality of electrodes on the back surface of the substrate are described as being disposed in a 12 by 12 grid; however, the number and disposition of these electrodes are not limited to this. For example, the electrodes on the back surface of the substrate may be disposed in a 26 by 26 grid or a 30 by 30 grid.

Furthermore, in the first, second, and fourth examples above, the plurality of electrodes on the back surface of the substrate may be a full grid disposed in complete 12 by 12 rows and columns; however, a portion of the electrodes may not be formed. For example, according to one or more embodiments as illustrated in (a) of FIG. 9, electrodes are formed in only a portion of the regions (center portion and peripheral portion) of the back surface of the substrate but electrodes may not be formed in other regions, and basic function electrodes are formed in the back surface center portion but additional function electrodes may not be formed on the back surface center portion.

Semiconductor packages that have a configuration such as this can also prevent the occurrence of wasteful balls unrelated to operation and, therefore, achieve a similar effect to the above embodiments.

Furthermore, the electrodes with balls not formed among the plurality of electrodes on the substrate may be solder plate processed. As a result, there is reliability against corrosion.

Furthermore, in each of the above embodiments, operating the basic functions of this semiconductor package is necessary to operate by the additional functions of the semiconductor package. That is, the configuration of the semiconductor package operating by the additional functions comprises the configuration of the semiconductor package operating by the basic functions. Specifically, balls may be formed on the basic function electrodes of the semiconductor package that operates by the additional functions. However, configurations of the semiconductor package are not limited to this. For example, balls may not be formed on the basic function electrodes of the semiconductor package that operates by the additional functions. That is, the semiconductor package that operates by the additional functions has balls formed on the additional function electrodes but may not have balls formed on the basic function electrodes. Meanwhile, the semiconductor package that operates by the basic functions does not have balls formed on the additional function electrodes but may have balls formed on the basic function electrodes. Furthermore, a portion of the plurality of basic function electrodes and a portion of the plurality of additional function electrodes may be the same. For example, a portion of the plurality of electrode balls formed in the semiconductor package that operates by the basic functions and a portion of the electrode balls formed in the semiconductor package that operates by the additional functions, may be the same.

Furthermore, in the above embodiments, the plurality of electrodes corresponding to the plurality of functions that the semiconductor chip may have are respectively illustrated as configurations that are disposed in an aggregated manner and as configurations that are disposed in a distributed manner; however, the disposition of the electrodes is not limited to this, and a portion of the plurality of electrodes corresponding to the plurality of functions may be disposed in an aggregated manner, respectively, and the remaining portion maybe disposed in a distributed manner. For example, a portion of the plurality of basic function electrodes in the center region of the back surface of the substrate may be disposed in an aggregated manner, and a portion of the plurality of additional function electrodes in a first region that encloses the center region may be disposed in an aggregated manner, while the remainder of the plurality of basic function electrodes and the remainder of the plurality of additional function electrodes may be disposed in a distributed manner in a second region that encloses the first region.

Furthermore, in the above embodiments, basic functions and additional functions are described as two examples of functions the semiconductor chip has, but the number of functions that the semiconductor chip has may be three or more.

Furthermore, in the fourth example above, the evaluation electrodes 1021Bmay be disposed in the corners (four corners) of the back surface of the substrate 1020; however, the disposition of the evaluation electrodes 1021B is not limited to this. For example, the additional function region 1023 or the center region 1022A may be cut away, and the evaluation electrodes 1021 B may be placed in the cut away region. That is, the additional function electrodes and the basic function electrodes and the evaluation electrodes 1021B may be disposed interchangeably.

In addition, the above embodiments and the above modifications may be respectively combined.

### [Industrial Applicability]

For example, the semiconductor package according to one or more embodiments of the present invention may be useful as a BGA package or the like mounted to a consumer device such as a television.

Although the disclosure has been described with respect to only a limited number of embodiments, those skilled in the art, having benefit of this disclosure, will appreciate that various other embodiments may be devised without departing from the scope of the present invention. Accordingly, the scope of the invention should be limited only by the attached claims

### [Description of the Reference Numbers]

- 100, 300, 500, 700, 900A, 900B, 1000A, 1000B: semiconductor package
- 110: semiconductor chip
- 120, 520, 920A, 920B, 1020: substrate
- 121,521: electrode
- 121A, 521A, 921A: basic function electrode
- 121B, 521B: additional function electrode
- 122, 922, 1022: basic function region
- 122A, 522, 923, 1022A: center region
- 122B, 924, 1022B: peripheral region
- 123, 1023: additional function region
- 130, 330, 530, 730, 930A, 930B, 1030A, 1030B: ball
- 200, 400, 600, 800: printed circuit board
- 201, 401, 601, 801: wiring
- 202, 402, 602, 802: via hole
- 251: first quadrant
- 252: second quadrant
- 253: third quadrant
- 254: fourth quadrant
- 921B: additional function electrode
- 925: additional function region
- 1021B: evaluation electrode

## Claims

1. A semiconductor package (100, 300, 500, 700, 900A, 900B, 1000A, 1000B), comprising:
a substrate (120, 520, 920A, 920B, 1020) comprising a top surface and a back surface;
a semiconductor chip (110) having a plurality of functions and mounted on the top surface of the substrate (120, 520, 920A, 920B, 1020); and
a plurality of balls (130, 330, 530, 730, 930A, 930B, 1030A, 1030B) formed on the back surface of the substrate (120, 520, 920A, 920B, 1020) configured to connect the substrate to an external substrate of the semiconductor package (100, 300, 500, 700, 900A, 900B, 1000A, 1000B), wherein,
the substrate (120, 520, 920A, 920B, 1020) further comprises a plurality of electrodes (121, 521) corresponding to the plurality of functions and formed on the back surface of the substrate (120, 520, 920A, 920B, 1020), and
a subset of the plurality of electrodes (121, 521) corresponds to a subset of the plurality of functions, and each of the plurality of balls (130, 330, 530, 730, 930A, 930B, 1030A, 1030B) is respectively disposed on each of the electrodes (121, 521) in the subset.

2. The semiconductor package (100, 300, 500, 700, 900A, 900B, 1000A, 1000B) according to claim 1, wherein
the back surface of the substrate (120, 520, 920A, 920B, 1020) comprises a plurality of regions (122, 922, 1022, 123, 1023) corresponding to the plurality of functions, and eac
h ofthe plurality of electrodes (121, 521) is respectively formed in the corresponding regions of the plurality of regions (122, 922, 1022, 123, 1023).

3. The semiconductor package (100, 300, 500, 700, 900A, 900B, 1000A, 1000B) according to claim 1, wherein
the electrodes (121, 521) in the subset that correspond to the subset of functions are disposed in a zigzag pattern.

4. The semiconductor package (100, 300, 500, 700, 900A, 900B, 1000A, 1000B) according to claim 3, wherein
the electrodes (121, 521) not in the subset correspond to functions other than the functions in the subset and are disposed adjacent to the electrodes (121, 521) that correspond to the subset of the functions.

5. The semiconductor package (100, 300, 500, 700, 900A, 900B, 1000A, 1000B) according to any of claims 1 to 4, wherein
a shape of the substrate (120, 520, 920A, 920B, 1020) as viewed from a direction perpendicular to the back surface is substantially rectangular,
each region of the substrate divided by line segments connecting the center of the substantially rectangular shape to midpoints of each side that configure the substantially rectangular shape is a quadrant (251, 252, 253, 254).

6. The semiconductor package (100, 300, 500, 700, 900A, 900B, 1000A, 1000B) according to claim 5, wherein
each quadrant (251, 252, 253, 254) contains the same number of electrodes corresponding to the portion of the functions.

7. The semiconductor package (100, 300, 500, 700, 900A, 900B, 1000A, 1000B) according to any of claims 1 to 4, wherein
the plurality of electrodes (121, 521) comprises power electrodes that correspond to the subset of the functions and correspond to power or ground of the functions, wherein the power electrodes are formed on the center of the back surface of the substrate (120, 520, 920A, 920B, 1020).

8. The semiconductor package (100, 300, 500, 700, 900A, 900B, 1000A, 1000B) according to any of claims 1 to 5, wherein
the substrate (120, 520, 920A, 920B, 1020) further comprises evaluation electrodes (1021b) formed on the back surface of the substrate (120, 520, 920A, 920B, 1020).
